Europäisches Patentamt

European Patent Office

Office européen des brevets

(11) Veröffentlichungsnummer: **0 195 294 B1**

## (12) EUROPÄISCHE PATENTSCHRIFT

(45) Veröffentlichungstag der Patentschrift: **13.05.92**

(21) Anmeldenummer: **86102683.9**

(22) Anmeldetag: **01.03.86**

(51) Int. Cl.⁵: **H03G 1/00**

(54) Regelschaltung.

(30) Priorität: **16.03.85 DE 3509594**

(43) Veröffentlichungstag der Anmeldung:
**24.09.86 Patentblatt 86/39**

(45) Bekanntmachung des Hinweises auf die
Patenterteilung:
**13.05.92 Patentblatt 92/20**

(84) Benannte Vertragsstaaten:
**AT CH FR GB IT LI NL SE**

(56)  Entgegenhaltungen:
**DE-B- 1 069 697**
**US-A- 3 988 692**

(73) Patentinhaber: **TELEFUNKEN electronic GmbH**
**Theresienstrasse 2**
**W-7100 Heilbronn(DE)**

(72) Erfinder: **Böhme, Rolf, Dr. Dipl.-Ing.**
**Sudetenstrasse 1**
**W-7107 Bad Friedrichshall(DE)**

(74) Vertreter: **Maute, Hans-Jürgen, Dipl.-Ing.**
**TELEFUNKEN electronic GmbH Theresien-**
**strasse 2**
**W-7100 Heilbronn(DE)**

## Beschreibung

Bipolare Transistoren weisen die vorteilhafte Eigenschaft auf, daß ihre Steilheit in einem weiten Bereich proportional zum Kollektorstrom ist. Dies wird bei üblichen Differenztransistor-Schaltungen ausgenutzt, wobei der den Emittern zufließende Strom einstellbar ist und dieser die Steilheit und damit Verstärkung der Differenzstufe festlegt. Dieses Prinzip findet auch bei den sogenannten Transkonduktanz-Verstärkern sowie bei Multiplizierern Anwendung. Die bei Regelverstärkern mit großem Regelbereich erwünschte, exponentielle Charakteristik kann ebenfalls mit bipolaren Transistoren durch den exponentiellen Zusammenhang zwischen Basis-Emitter-Spannung und Kollektorstrom leicht erzeugt werden.

Aus "Halbleiter Schaltungstechnik", Tietze, Schenk, Springerverlag, 6. Auflage, Berlin, 1983, "Linear Databook", National Semiconductor Corporation, 1982, Santa Clara, USA und "Circuits integres lineaires professionnels", cataloque, Thomson-EFCIS, Genoble, 1982 sind Regelverstärker bekannt, bei denen ein Transistorpaar einen Eingangs-Differenzverstärker bildet. Eine Transistorstromquelle dient dabei als Arbeitswiderstand für einen der beiden Verstärker-Transistoren. Der Strom der Transistorstromquelle ist jedoch nicht konstant, sondern wird vom Strom durch einen weiteren Transistor bestimmt der zusammen mit der Transistorstromquelle einen Stromspiegel bildet. Der Eingangsstrom des Stromspiegels ist der Ausgangsstrom des zweiten Transistors des Eingangs-Differenzverstärkers. Der Ausgangsstrom des Stromspiegels entspricht somit der Differenz der Kollektorströme des Transistorpaars des Eingangs-Differenzverstärkers. In einem sich anschließenden Schaltungsteil wird der Ausgangsstrom in eine Spannung umgewandelt.

Diese bekannte Schaltungstechnik mit bipolaren Transistoren eignet sich für Versorgungsspannungen ab etwa zwei bis drei Volt, weil drei bis vier in Serie betriebene Transistoren funktionsfähige Arbeitspunkte haben müssen. Bei Versorgungsspannungen unter etwa zwei Volt versagen die bekannten Schaltungen.

Der Erfindung liegt die Aufgabe zugrunde, eine Regelschaltung anzugeben, die bei kleiner Batteriespannung und beispielsweise bereits bei der Spannung einer elektrolytischen Zelle von nur 1,2 bis 1,6 Volt eine leistungsfähige Regelung mit großem Regelbereich ermöglicht. Diese Aufgabe wird durch eine Regelschaltung gelöst, die nach der Erfindung einen ersten, in Emitterschaltung betriebenen Transistor, einen zweiten, in Emitterschaltung betriebenen Transistor sowie als Ausgangstransistoren einen dritten und einen vierten Transistor aufweist, daß die Ausgangstransistoren zum ersten und zweiten Transistor komplementär sind, daß die Basen der Ausgangstransistoren untereinander sowie mit einem ersten Anschluß eines ersten Widerstands und einem ersten Anschluß eines zweiten Widerstands verbunden sind, daß der Kollektor des dritten Transistors mit dem Kollektor des ersten Transistors und einem zweiten Anschluß des ersten Widerstands verbunden ist, daß der Kollektor des vierten Transistors mit dem Kollektor des zweiten Transistors sowie mit einem zweiten Anschluß des zweiten Widerstands verbunden ist, daß zur Ansteuerung des ersten und zweiten Transistors eine Steuerspannungsquelle vorgesehen ist und daß außerdem eine Signalquelle vorhanden ist, die zusammen mit der Steuerspannungsquelle mindestens einen der beiden Transistoren ansteuert.

Die Erfindung wird im folgenden an Ausführungsbeispielen erläutert.

Die Figur 1    zeigt eine Grundform der erfindungsgemäßen Regelstufe,

die Figur 2    zeigt die Kombination der Steuerspannungsquelle mit zwei im Gegentakt arbeitenden Signalquellen,

die Figur 3    zeigt eine indirekte Form der Steuerung mit symmetrischer Signalquelle,

die Figur 4    zeigt die kapazitive Ankopplung einer unsymmetrischen Signalquelle,

die Figur 5    zeigt eine indirekte Form der Steuerung mit Bezug auf die Ausgangstransistoren,

die Figur 6    zeigt eine Regelstufe mit npn-pnp-Paarung für asymmetrischen Eingang,

die Figur 7    zeigt eine Regelstufe nach Figur 6 mit Symmetrierung der Aussteuerung,

die Figur 8    zeigt eine Kaskadierung zweier zueinander komplementärer Regelstufen,

die Figur 9    zeigt eine Anpassung der zweiten Regelstufe durch Vorwiderstände,

die Figur 10   zeigt eine Ausgangsstufe mit regelabhängiger Mitkopplung,

die Figur 11   zeigt einen Übersteuerungsschutz,

die Figur 12   zeigt eine andere Ausführungsform des Übersteuerungsschutzes,

die Figur 13   zeigt einen driftkompensierten Regelverstärker.

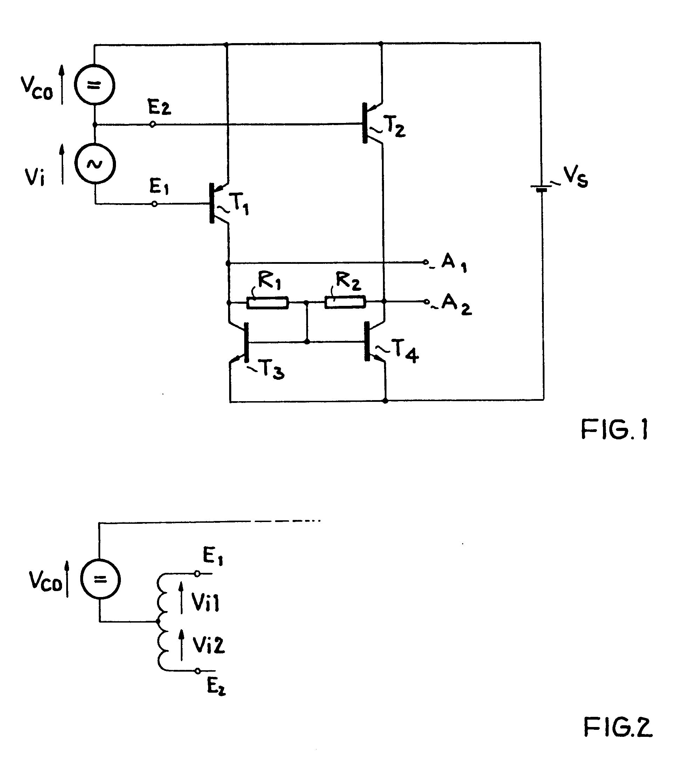

Die Figur 1 zeigt eine Regelschaltung nach der Erfindung mit einem ersten Transistor T1, einem zweiten Transitor T2 und den Ausgangstransistoren T3 und T4. Bei dieser Schaltung sind die Kollektoren der Transistoren T1 und T3 sowie die Kollektoren der Transistoren T2 und T4 miteinander verbunden. Das eine Ende des Widerstandes R1 ist mit den Kollektoren der Transistoren T1 und T3 und das eine Ende des Widerstandes R2 ist mit den Kollektoren der Transistoren T2 und T4 verbunden. Die anderen Enden der Widerstände R1 und R2 sind mit den Basen der Transistoren T3 und T4 verbunden. Die Kollektorverbindung der Transistoren T1 und T3 führt zu dem einen Ausgang A1 der Schaltung und die Kollektorverbindung der Transistoren T2 und T4 führt zu dem anderen Ausgang A2 der Schaltung. Die Emitter der Transistoren T1 und T2 sind mit dem einen Pol der Spannungsquelle Vs und die Emitter der Transistoren T3 und T4 sind mit dem anderen Pol der Spannungsquelle Vs verbunden.

Bei der Anordnung der Fig. 1 werden der erste Transistor T1 und der zweite Transistor T2 in Emitterschaltung betrieben. Der zweite Transistor T2 der Schaltung der Figur 1 wird durch die Steuerspannungsquelle Vco angesteuert, während der erste Transistor T1 dieser Schaltung durch die Steuerspannungsquelle Vco und die Signalquelle Vi angesteuert wird.

Die Widerstände R1 und R2 sind so dimensioniert, daß im Verhältnis zur Basis-Emitter-Spannung nur ein geringer Gleichspannungsabfall auftritt. Infolge der verbundenen Basen führen die Transistoren T3 und T4 untereinander nahezu gleiche Ströme. Wenn über die Anschlußklemmen A1, A2 keine Ströme abfließen, müssen diese Ströme mit den Ruhewerten der Ströme der Transistoren T1 und T2 übereinstimmen. Bei Aussteuerung an den Eingängen E1, E2 werden die Ströme der Transistoren T1 und T2 untereinander verschieden. Die Abweichung von der Symmetrie kann nur über die Widerstände R1, R2 ausgeglichen werden. Sie führen deshalb Spannungsabfälle entsprechend der Strom-Unsymmetrie. Somit ersetzen die Widerstände R1, R2 die üblichen Arbeitswiderstände, wobei durch die Transistoren T3, T4 ihr Ruhespannungsabfall stark reduziert wird. Das bedeutet, daß sich das Ruhepotential an den Ausgangsklemmen A1, A2 nur wenig ändert, auch wenn ein großer Regelbereich durchlaufen wird. Insbesondere ermöglicht dieses Prinzip die beschriebene Kettenschaltung zueinander komplementärer Regelstufen.

Bei der beschriebenen Anordnung wie auch bei allen folgenden Anordnungen sind jeweils zwei Transistoren hinsichtlich der Kollektor-Emitter-Spannung in Reihe geschaltet. Mit üblichen Si-Transistoren sind diese Schaltungen ab etwa 1 V Versorgungsspannung funktionsfähig.

Bei der Anordnung nach Fig. 1 wird dem ersten Transistor T1 die Signalspannung Vi und die Steuerspannung Vco zugeführt. Der zweite Transistor T2 erfährt durch die Steuerspannung Vco nur eine statische Aussteuerung. Obwohl die Ausgangstransistoren T3, T4 mit den Widerständen R1, R2 symmetrierende Eigenschaften haben, bleibt eine Gleichtakt-Komponente an den Ausgängen A1, A2 erhalten.

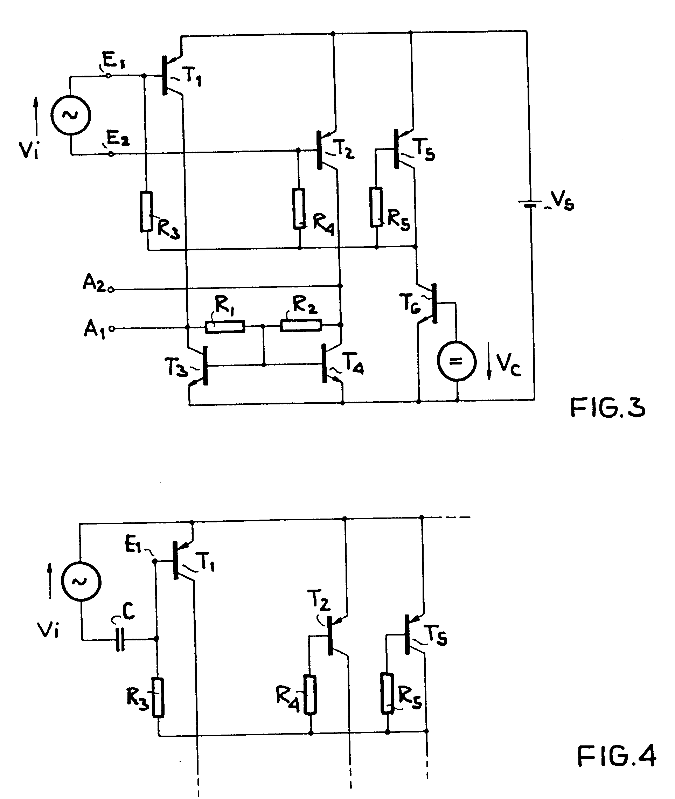

Die Fig. 2 zeigt eine Ausführungsform der Erfindung, bei der die Gleichtakt-Komponente an den Ausgängen A1, A2 unterdrückt wird. Bei dieser Schaltung ist dem ersten Transistor T1 eine erste Signalquelle Vi1 und dem zweiten Transistor T2 eine zweite Signalquelle Vi2 vorgeschaltet. Dabei wird also der erste Transistor T1 durch die Steuerspannungsquelle Vco sowie durch die Signalquelle Vi1 angesteuert, während der zweite Transistor T2 durch die Steuerspannungsquelle Vco und die Signalquelle Vi2 angesteuert wird.

Bestehen die beiden Signalquellen Vi1, Vi2 gemäß der Fig. 2 aus einer mittenangezapften Übertragerwicklung, so ergibt sich eine vorteilhafte Gegentakt-Aussteuerung der Regelschaltung und die Gleichtakt-Komponente der Spannungen an den Ausgängen A1, A2 verschwindet. Mit einer symmetrischen Signalquelle ohne Mittenanzapfung kommt die in Fig. 3 gezeigte Regelschaltung aus. Sie enthält eine erweiterte Form der Steuerspannungsquelle Vco, die aus einer Steuerspannungsquelle Vc, den beiden Transistoren T5 und T6 sowie aus den drei Widerständen R3, R4 und R5 besteht. Die Steuerspannungsquelle Vc ist an Basis und Emitter des sechsten Transistors T6 angeschlossen. Der Kollektor des sechsten Transistors T6 ist mit dem Kollektor des fünften Transistors T5 sowie mit den drei Widerständen R3, R4 und R5 verbunden. Der dritte Widerstand R3 ist mit der Basis des ersten Transistors T1, der vierte Widerstand R4 ist mit der Basis des zweiten Transistors T2 und der fünfte Widerstand R5 ist mit der Basis des fünften Transistors T5 verbunden. Die Signalquelle Vi ist symmetrisch mit den Basen des ersten Transistors T1 und des zweiten Transistors T2 verbunden.

Die Steuerspannungsquelle Vc steuert den Transistor T6, so daß dieser einen zu Vc exponentiellen Strom abgibt. Dieser Strom fließt zum größten Teil dem Kollektor von T5 zu, wobei sich durch die Basisstromzuführung über den Widerstand R5 die zugeordnete Basis-Emitter-Spannung des Transistors T5 einstellt. Die Widerstände R3, R4, R5 sind so dimensioniert, daß die Spannungsabfälle klein gegen die Versorgungsspannung Vs sind. In einer bevorzugten Ausführungsform sind die Transistoren T1, T2 und T5 wie auch die Widerstände R3, R4 und R5 untereinander gleich. Dann ergeben sich gleiche Arbeitspunkte und auch gleiche Ströme dieser Transistoren. Die Ströme der Transistoren T1, T2 sind somit dem Strom des Stromquellentransistors T6 nahezu gleich, lediglich vermindert um die durch R3, R4 und R5 fließenden Basisströme der drei Transistoren T1, T2 und T5. Somit sind auch die Steilheiten der Transistoren T1 und T2 nahezu linear vom Strom des Transistors T6 und exponentiell von der Steuerspannung Vc abhängig.

In hochfrequenztechnischen Anwendungen hat die Eingangssignalquelle häufig die Form eines Resonanzkreises oder eines Resonanz-Übertragers. Dieser ist im Normalfall galvanisch mit einer Klemme der Versorgungsspannung verbunden. Es ist möglich, von einer solchen Signalquelle ausgehend über einen Koppelkondensator C die Regelschaltung anzusteuern, wie dies in Fig. 4 dargestellt ist, wobei diese Schaltung in allen übrigen Einzelheiten Fig. 3 entspricht. Der Koppelkondensator C führt zum Eingang E1 der Schaltung, während der Eingang E2 unbeschaltet bleibt. Die unsymmetrische Ansteuerung führt dann zu einer Gleichtaktkomponente in den Ausgangsspannungen, die unerwünscht sein kann.

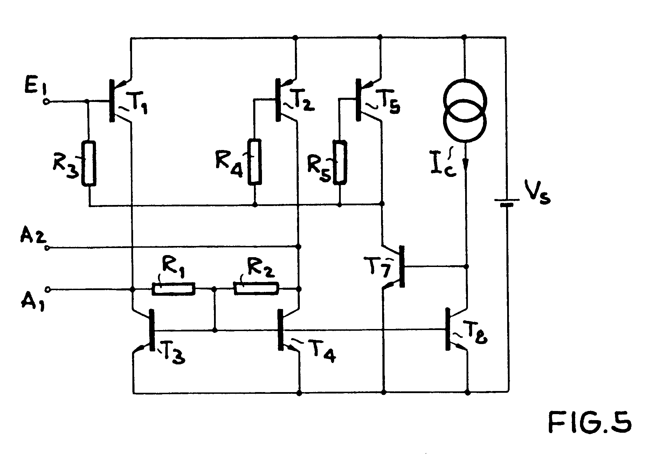

Zur Unterdrückung der Gleichtaktkomponente kann die in Fig. 5 dargestellte Ausführungsform herangezogen werden. Hier besteht die Steuerspannungsquelle Vco aus einer Steuerstromquelle Ic, einem Überwachungstransistor T8, einem Stromquellentransistor T7 sowie einem Transistor T5 und Widerständen R3, R4, R5, wie bereits anhand von Fig. 3 beschrieben. Der Überwachungstransistor T8 ist an Basis und Emitter den Ausgangstransistoren parallel geschaltet und führt infolgedessen den gleichen Strom wie diese bzw. einen Strom im Verhältnis der aktiven Basis-Emitter-Flächen. Sein Kollektor ist mit der Steuerstromquelle Ic und der Basis des Stromquellentransistors T7 verbunden. Der Kollektor des Stromquellentransistors T7 führt zum Verbindungspunkt der Widerstände R3, R4, R5 mit dem Kollektor des Transistors T5.

Die Funktion der Schaltung beruht darauf, daß nunmehr über einen Regelkreis der Strom der beiden Transistoren T3, T4 eingestellt wird. Stimmt deren durch T8 gemessener Strom nicht mit dem von der Steuerstromquelle Ist gelieferten Strom überein, so erfolgt über T7 und die Basisvorwiderstände R1, R2 eine Nachführung auf den Sollwert. Hierbei sind Transistor T5 mit Widerstand R5 nicht funktionsnotwendig, sie wirken sich aber günstig auf Stabilität und Dynamik aus.

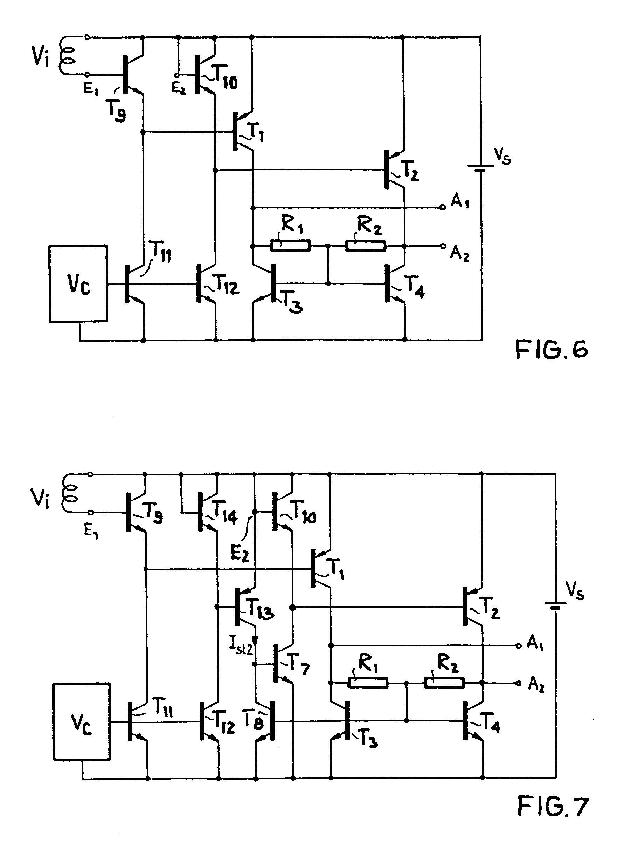

Bei der Anordnung der Fig. 6 kann die Signalquelle in den typischen Anwendungen direkt mit der Regelschaltung ohne Koppelkondensator verbunden werden. Hierzu sind den Transistoren T1 und T2 Emitterfolger mit den Transistoren T9 und T10 vorgeschaltet, wobei die Transistoren T9 und T10 komplementär zu den Transistoren T1 und T2 sind. Der Basis-Anschluß E2 des T2 vorgeschalteten Transistors T10 wird nicht gesteuert und ist mit der positiven Klemme der Versorgungsspannung Vs verbunden. Am Basisanschluß E1 des dem Transistor T1 vorgeschalteten Transistors T9 wird die Eingangssignalquelle Vi angeschlossen. Der Strom durch die Emitterfolger T9, T10 wird durch Stromquellentransistoren T11, T12 erzeugt, die von der Steuerspannung Vc gesteuert werden. Der Spannungsabfall Basis-Emitter der Emitterfolger wird der Emitter-Basis-Strecke der Transistoren T1, T2 zugeführt. Die Transistoren T9, T10 sind zwar zu T1, T2 komplementär, doch kann man durch Aussuchen geeigneter Typen bzw. bei Ausführung in integrierter Technik durch Wahl des Flächenverhältnisses dafür sorgen, daß die Ströme der Transistoren T11, T12 mit denen von T1, T2 übereinstimmen bzw. in einem erwünschten Verhältnis stehen, und zwar unabhängig von ihrer durch die Steuerspannung Vc bestimmten absoluten Größe. Da die Änderung der Steuerspannung und damit Verstärkung nicht mit der Umladung von Koppel- und Siebkondensatoren verbunden ist, eignet sich die Ausführungsform der Fig. 6 auch für tiefe Frequenzen, z. B. zur stoßfreien Steuerung von NF-Signalen.

Die Anordnung der Fig. 7 zeigt, wie die Signalverarbeitung vollkommener symmetriert werden kann. Dazu ist vorgesehen, daß der vom zweiten Regeltransistor T12 erzeugte Strom zunächst an einem npn-pnp-Stromspiegel (T13, T14) gespiegelt wird, was den Strom Ist2 ergibt. Der Strom Ist2 wird mit Hilfe des Meß-Transistors T8 mit dem Strom der Ausgangstransistoren T3, T4 verglichen. Die Differenz der Ströme steuert den Transistor T7. Der Transistor T7 treibt einen Strom durch den Transistor T10. Der Spannungsabfall am Transistor T10 steuert den zweiten Transistor T2, der weiter auf den zweiten Ausgangstransistor T4 wirkt. Somit werden jetzt die in T3 und T4 fließenden Ströme konstant gehalten. Die Verkopplung bewirkt, daß die Transistoren T10, T2 im Gegentakt zu T9, T1 gesteuert werden und eine Gleichtaktkomponente der Ausgänge A1, A2 unterdrückt wird.

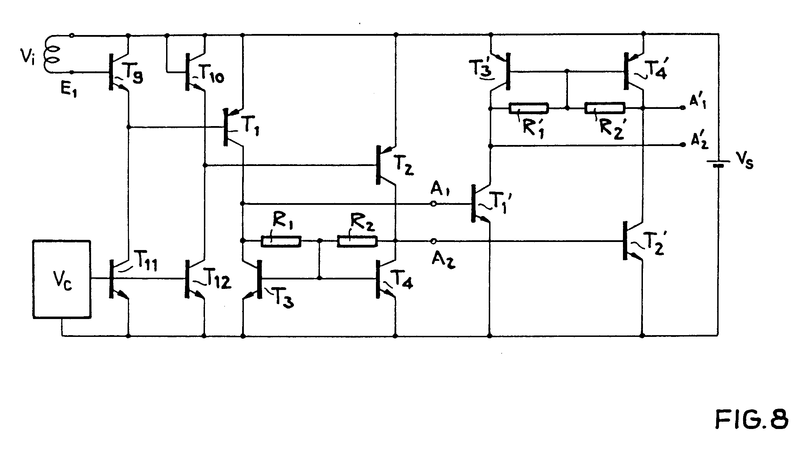

Die beschriebenen Regelschaltungen sind kaskadierbar, wie in der Fig. 8 am Beispiel der Schaltung nach Fig. 6 gezeigt ist. Dabei wechseln sich die Leitfähigkeitstypen ab, d.h., einer pnp-npn-Konfiguration folgt eine npn-pnp-Konfiguration. An die Ausgänge A1, A2 der ersten Regelschaltung ist eine zweite Regelschaltung mit den Transistoren T1', T2', T3', T4' angeschlossen. Soweit die Spannungsabfälle an den Widerständen R1, R2 vernachlässigbar sind, haben die Eingangstransistoren T1', T2' der zweiten Kaskade im Ruhezustand die gleiche Basis-Emitter-Spannung wie die Ausgangstransistoren T3, T4 der ersten Kaskade. Infolgedessen sind auch ihre Ströme gleich groß bzw. in einer integrierten Schaltung entsprechend dem Flächenverhältnis gestuft. Die von der Steuerspannung Vc abhängige Größe der Arbeitsströme setzt sich in die zweite Kaskade hinein fort, so daß bei einer Kette von mehreren Regelstufen die vorangehende automatisch die nachfolgende mit einstellt. Der Regelumfang einer Kette von Regelstufen ist das Produkt des Regelumfangs einer Einzelstufe. Dies ist in hochfrequenten Anwendungen wichtig, wenn der Regelumfang einer Einzelstufe wegen des Rückgangs der oberen Grenzfrequenz mit sinkendem Arbeitstrom nicht sehr groß gemacht werden kann.

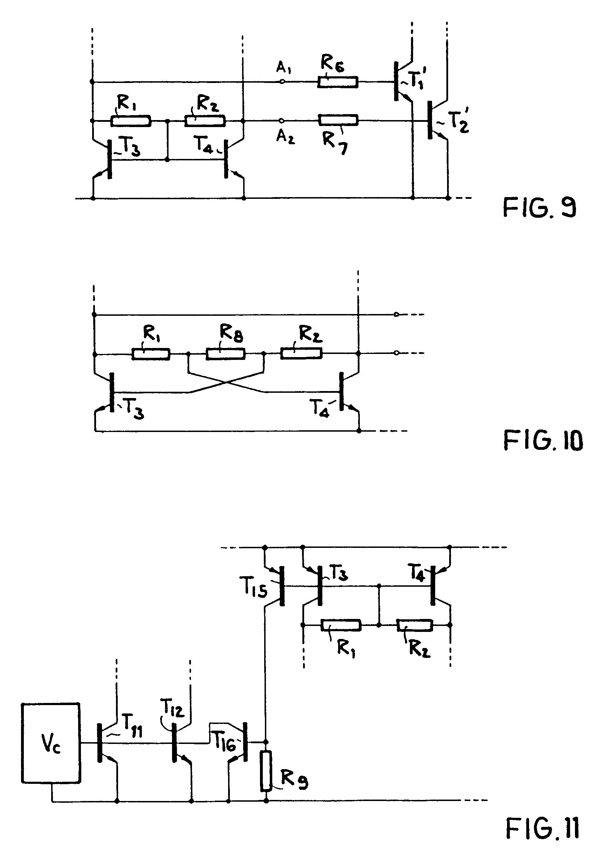

Die oben gemachte Voraussetzung, daß die Ruhespannungsabfälle über den Widerständen R1, R2 hinreichend klein sind, ist unter Umständen bei hohen Regelströmen und damit Basis-Strömen nicht leicht einzuhalten. Die Basis-Spannung der Transistoren T1', T2' steigt dann stärker an als die der Transistoren T3, T4 und die Arbeitsströme der zweiten Kaskade nehmen überproportional zu. Diese Schwierigkeit wird entsprechend der Fig. 9 durch die Einführung von Widerständen R6, R7 vor den Basen der Transistoren T1', T2' der zweiten Regelstufe beseitigt. Die Vorwiderstände R6, R7 werden so gewählt, daß ihre Spannungsabfälle den Abfällen über R1 bzw. R2 entsprechen.

Unabhängig von der Anwendung dieser Vorwiderstände nimmt der Eingangswiderstand der zweiten Regelstufe mit steigendem Arbeitsstrom ab und führt zu einem Verlust an Verstärkung bei hohem Arbeitsstrom. Zur Kompensation dieses Effektes ist nach Fig. 10 vorgesehen, die aus den Transistoren T3, T4 und Widerständen R1, R2 gebildete Schaltungseinheit dahingehend zu erweitern, daß zwischen die beiden Widerstände R1, R2 ein gegenüber seinen Nachbarn kleiner Widerstand R8 seriell eingefügt wird und daß die Basis des linken Transistores T3 am rechten Verbindungspunkt R8-R2 und die Basis des rechten Transistors T4 am linken Verbindungspunkt R1-R8 angeschlossen wird. Durch diesen Widerstand kommt es innerhalb dieses Schaltungsteiles zu einer Mitkopplung, die stromproportional ansteigt und dem Verstärkungsverlust bei hohen Strömen entgegenwirkt.

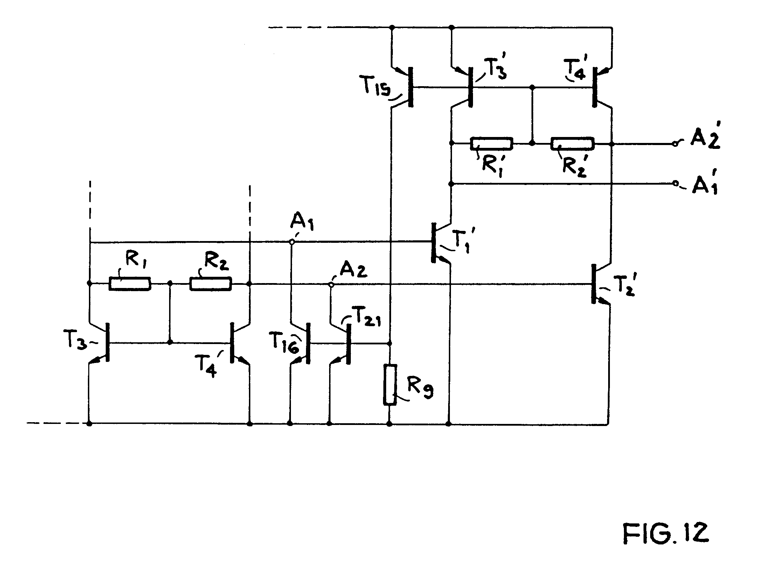

Wenn den Ausgangstransistoren T3, T4 eine Schaltung zur Überwachung des Arbeitspunktes wie in Fig. 7 oder zur Erkennung von Übersteuerungen wie in Fig. 11 beigeordnet ist, empfiehlt es sich den Mitkoppelwiderstand R8 mit einer Mittenanzapfung zu versehen und die Überwachungsschaltung an der Mittenanzapfung anzuschließen.

Bei der Verbindung zweier Regelstufen wie in Fig. 8 kann es geschehen, daß eine starke Aussteuerung an einem der Ausgänge A1, A2 der ersten Regelstufe einen unverhältnismäßig hohen Strom in einem der Eingangstransistoren T1', T2' der zweiten Regelstufe auslöst. Dies kann mit der in Fig. 11 dargestellten Schutzschaltung vermieden werden. Dabei ist ein Transistor T15 an Basis und Emitter den Transistoren T3 und T4 parallel geschaltet. Bei gleicher Konstruktion (Emitter-Basis-Fläche und Dotierung) führt der Transistor T15 den gleichen Strom wie die Transistoren T3 und T4. Vorteilhaft kann es aber auch eine kleinere Konstruktion mit kleinerem Strom sein. Der am Kollektor des Transistors T15 austretende Strom wird in den Widerstand R9 geleitet und ruft dort einen Spannungsabfall hervor. Der Spannungsabfall steuert den Transistor T16. Der Kollektor von T16 ist beispielsweise mit der Steuerspannungsquelle Vc verbunden. Im Normalbetrieb ist der Spannungsabfall am Widerstand R9 so klein, daß T16 gesperrt bleibt. Kommt es jedoch zu einer unzulässigen Stromhöhe in den Transistoren T3, T4 und T15, so wird T16 leitend und schließt die Steuerspannung Vc kurz bzw. verhindert deren weiteres Anwachsen, so daß die Ströme der Schaltung begrenzt bleiben.

Bei der Ausführungsform der Fig. 12 ist der Kollektor des Transistors T16 nicht mit der Steuerspannung Vc, sondern mit einem Ausgang A1 der vorausgehenden Regelstufe verbunden. Ein weiterer Transistor T21 ist an Emitter und Basis zum Transistor T16 parallel geschaltet und hat den Kollektor am Ausgang A2 der vorausgehenden Regelstufe. Im Übersteuerungsfall werden die Ausgänge kurzgeschlossen und damit wird die Entstehung kritischer Stromwerte in der zweiten Regelstufe verhindert. Die beschriebenen Schutzmethoden sind auch in Schaltungen mit mehr als zwei Regelstufen sinngemäß anwendbar.

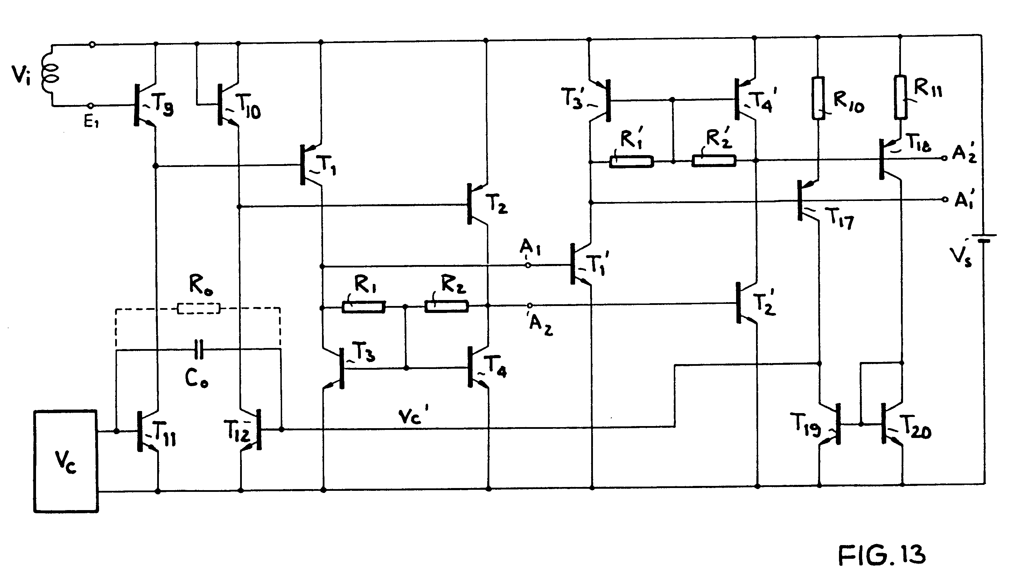

Die vorgeschlagenen Regelschaltungen sind direkt gekoppelte Verstärker, die auch Gleichgrößen übertragen. Die stets vorhandenen Abweichungen von der Symmetrie führen insbesondere bei hohen Verstärkungen zu Abweichungen von den vorgesehenen Arbeitspunkten. Wenn die zu regelnden Signale eine untere Grenzfrequenz haben, kann der Arbeitspunkt durch eine tieffrequente Gegenkopplung stabilisiert werden. Zu diesem Zweck ist vorgesehen, die in den Figuren 6 bis 8 dargestellte Verbindung zwischen den Basen des ersten und zweiten, Regelstrom erzeugenden Transistors T11, T12 durch einen Kondensator Co zu ersetzen, dem ein Widerstand Ro parallel geschaltet sein kann. Die Basis des zwölften Transistors T12 wird, wie in Fig. 13 dargestellt, mit einer sekundären Steuerspannung Vc' verbunden. Die sekundäre Steuerspannung Vc' wird aus den Ausgangsspannungen der letzten, im Beispiel von Fig. 13 zweiten Regelstufe gewonnen. Dies erfolgt durch zwei Transistoren T17, T18, die mit ihren Basen an den Ausgängen A1', A2' angeschlossen sind und die auf einen Stromspiegel T19, T20 arbeiten. Die Emitter der Transistoren T17, T18 sind direkt oder über Widerstände R10, R11 mit der zugeordneten Klemme der Versorgungsspannung Vs verbunden. Die sekundäre Steuerspannung Vc wird am Ausgang des Stromspiegels T19, T20 entnommen.

Kommt es durch Unsymmetrie zu einer Potentialdifferenz zwischen den beiden Ausgängen A1', A2' der zweiten Regelstufe, so unterscheiden sich die von den Transistoren T17, T18 erzeugten Ströme. Mittels des Stromspiegels T19, T20 wird die Stromdifferenz zum Kondensator Co geleitet und lädt diesen gegenüber der primären Steuerspannung Vc. Die sekundäre Steuerspannung besteht aus der Summe von primärer Steuerspannung und der erzeugten Kondensatorspannung an Co. Der Unterschied der beiden Steuerspannungen ergibt eine unterschiedliche Ansteuerung der beiden, Steuerstrom erzeugenden Transistoren T1' und T2' der zweiten Regelstufe. Der Unterschied bewirkt bei richtiger Polung den Abbau der schädlichen Unsymmetrie. Die Anordnung des Kondensators Co zwischen den beiden Steuerspannungen hat den Vorteil, daß Änderungen der primären Steuerspannung die sekundäre Steuerspannung mitführen, so daß keine direkte Beeinträchtigung des Zeitverhaltens der Regelschaltung auftritt und die Zeitkonstante der Arbeitspunktkorrektur unabhängig und beliebig groß gegenüber der Zeitkonstante der Regelschaltung sein kann. Der Kondensator Co muß so groß sein, daß die vorgesehene, dynamische Aussteuerung des Ausgangs des Regelverstärkers, die einen Wechselstrom zum Kondensator Co zur Folge hat, keine unzulässige Wechselspannung über Co erzeugt. Der Widerstand Ro sorgt für die Nachführung der sekundären Steuerspannung, wenn der Regelverstärker ganz oder nahezu gesperrt ist und die Transistoren T14 bis T17 keine ausreichenden Ströme führen.

**Patentansprüche**

1. Regelschaltung, insbesondere für kleine Versorgungsspannungen, die einen ersten, in Emitterschaltung betriebenen Transistor (T1), einen zweiten, in Emitterschaltung betriebenen Transistor (T2) sowie als Ausgangstransistoren einen dritten Transistor (T3) und einen vierten Transistor (T4) aufweist, wobei die Ausgangstransistoren (T3, T4) zum ersten und zweiten Transistor (T1, T2) komplementär sind, dadurch gekennzeichnet, daß die Basen der Ausgangstransistoren (T3, T4) untereinander sowie mit einem ersten Anschluß eines ersten Widerstands (R1) und einem ersten Anschluß eines zweiten Widerstands (R2) verbunden sind, daß der Kollektor des dritten Transistors (T3) mit dem Kollektor des ersten Transistors (T1) und einem zweiten Anschluß des ersten Widerstands (R1) verbunden ist, daß der Kollektor des vierten Transistors (T4) mit dem Kollektor des zweiten Transistors (T2) sowie mit einem zweiten Anschluß des zweiten Widerstands (R2) verbunden ist, daß zur Ansteuerung des ersten und zweiten Transistors (T1, T2) eine Steuerspannungsquelle (Vco) vorgesehen ist und daß außerdem eine Signalquelle (Vi) vorhanden ist, die zusammen mit der Steuerspannungsquelle (Vco) mindestens einen der beiden Transistoren (T1, T2) ansteuert.

2. Regelschaltung nach Anspruch 1, dadurch gekennzeichnet, daß sie zwei Eingänge (E1, E2) aufweist und daß die Basis des ersten Transistors (T1) den einen Eingang (E1) und die Basis des zweiten Transistors (T2) den anderen Eingang (E2) bildet.

3. Regelschaltung nach Anspruch 1 oder 2, dadurch gekennzeichnet, daß eine erste Signalquelle (Vi1) zwischen die Steuerspannungsquelle (Vco) und den ersten Eingang (E1) geschaltet ist, daß eine zweite Signalquelle (Vi2) zwischen die Steuerspannungsquelle (Vco) und den zweiten Eingang (E2) geschaltet ist und daß beide Signalquellen im Gegentakt zueinander arbeiten.

4. Regelschaltung nach einem der Ansprüche 1 bis 3, dadurch gekennzeichnet, daß die Steuerspannungsquelle (Vco) eine Steuerspannungsquelle (Vc), zwei Transistoren (T5, T6) sowie drei Widerstände (R3, R4, R5) aufweist, daß die Steuerspannungsquelle (Vc) den sechsten Transistor (T6) an Basis und Emitter steuert, daß der Kollektor des sechsten Transistors (T6) mit dem Kollektor des fünften Transistors (T5) sowie mit den drei Widerständen (R3, R4, R5) verbunden ist, daß der dritte Widerstand (R3) mit der Basis des ersten Transistors (T1), der vierte Widerstand (R4) mit der Basis des zweiten Transistors (T2) und der fünfte Widerstand (R5) mit der Basis des fünften Transistors (T5) verbunden ist und daß die Signalquelle (Vi) symmetrisch mit den Basen des ersten Transistors (T1) und des zweiten Transistors (T2) verbunden ist.

5. Regelschaltung nach einem der Ansprüche 1 bis 4, dadurch gekennzeichnet, daß die Signalquelle (Vi) kapazitiv mit einem der Eingänge verbunden ist.

6. Regelschaltung nach einem der Ansprüche 1 bis 5, dadurch gekennzeichnet, daß den Ausgangstransistoren (T3, T4) ein Überwachungstransistor (T8) zugeordnet ist, daß die beiden Ausgangstransistoren (T3, T4) und der Überwachungstransistor (T8) gemeinsame Basis- und gemeinsame Emitteranschlüsse aufweisen, daß eine Steuerstromquelle (Ic) und ein siebter Transistor (T7) vorgesehen sind, daß der Kollektor des Überwachungstransistors (T8) mit der Steuerstromquelle (Ic) sowie mit der Basis des siebten Transistors (T7) verbunden ist und daß der Kollektor des siebten Transistors (T7) am Verbindungspunkt der Vorwiderstände (R3, R4) angeschlossen ist.

7. Regelschaltung nach Anspruch 6, dadurch gekennzeichnet, daß der Verbindungspunkt der Vorwiderstände (R3, R4) mit dem Kollektor des sechsten Transistors (T6) mit dem Vorwiderstand (R5) und dem Kollektor des fünften Transistors (T5) verbunden ist und daß der Vorwiderstand (R5) mit der Basis des fünften Transistors (T5) verbunden ist.

8. Regelschaltung nach einem der Ansprüche 1 bis 7, dadurch gekennzeichnet, daß die Steuerspannungsquelle (Vco) zwei Emitterfolger (T9, T10) sowie zwei Transistorstromquellen (T11, T12) aufweist und daß der eine Emitterfolger (T9) dem ersten Transistor (T1) und der andere Emitterfolger (T10) dem zweiten Transistor (T2) vorgeschaltet ist.

9. Regelschaltung nach einem der Ansprüche 1 bis 8, dadurch gekennzeichnet, daß die beiden Transistorstromquellen (T11, T12) an den Basen und an den Emittern mit der Steuerspannungsquelle (Vc) und an den Kollektoren mit den Emittern der Emitterfolger (T9, T10) verbunden sind.

10. Regelschaltung nach einem der Ansprüche 1 bis 9, dadurch gekennzeichnet, daß ein Stromspiegel (T13, T14) vorgesehen ist, dem einer der Steuerströme zugeführt wird, und daß der Kollektor des Überwachungstransistors (T8) mit dem Ausgang des Stromspiegels (T13, T14) und der Basis des siebten Transistors (T7) verbunden ist und daß der Kollektor des siebten Transistors (T7) mit der Basis des zweiten Transistors (T2) verbunden ist.

11. Regelschaltung nach einem der Ansprüche 1 bis 10, dadurch gekennzeichnet, daß bei einer Hintereinanderschaltung mehrerer Regelstufen die Basen der Eingangstransistoren (T1', T2') einer nachfolgenden Regelstufe mit den Ausgängen (A1, A2) der vorhergehenden Regelstufe verbunden sind.

12. Regelschaltung nach einem der Ansprüche 1 bis 11, dadurch gekennzeichnet, daß die Eingangstransistoren (T1', T2') einer nachfolgenden Regelstufe die gleiche Leitungstypfolge wie die Ausgangstransistoren (T3, T4) der vorhergehenden Regelstufe aufweisen.

13. Regelschaltung nach einem der Ansprüche 1 bis 12, dadurch gekennzeichnet, daß zwischen die Ausgänge (A1, A2) einer vorhergehenden Regelstufe und die Basisanschlüsse der Eingangstransistoren (T1', T2') der folgenden Regelstufe Widerstände (R6, R7) geschaltet sind.

14. Regelschaltung nach einem der Ansprüche 1 bis 13, dadurch gekennzeichnet, daß die Basen der Ausgangstransistoren (T3, T4) einer Regelstufe über einen Mitkoppelwiderstand (R8) miteinander verbunden und über die Widerstände (R1, R2) mit den Kollektoren des jeweils anderen Ausgangstransistors (T4, T3) verbunden sind.

15. Regelschaltung nach einem der Ansprüche 1 bis 14, dadurch gekennzeichnet, daß ein fünfzehnter Transistor (T15) zur Überwachung von Übersteuerungen vorgesehen ist, der den Ausgangstransistoren (T3, T4) an Basis und Emitter parallel geschaltet ist und dessen Kollektor mit einem Arbeitswiderstand (R9) verbunden ist.

16. Regelschaltung nach einem der Ansprüche 1 bis 15, dadurch gekennzeichnet, daß ein sechzehnter Transistor (T16) mit der Basis am Verbindungspunkt vom Kollektor des fünfzehnten Transistors (T15) und dem Arbeitswiderstand (R9) angeschlossen ist und mit seinem Kollektor an der Steuerspannungsquelle (Vc) angeschlossen ist.

17. Regelschaltung nach einem der Ansprüche 1 bis 16, dadurch gekennzeichnet, daß mehrere Regelstufen vorhanden sind, daß der fünfzehnte Transistor (T15) am Ausgang einer nachfolgenden Regelstufe angeschlossen ist, daß dem sechzehnten Transistor (T16) an Basis und Emitter ein weiterer Transistor (T21) parallel geschaltet ist, daß der Kollektor des sechzehnten Transistors (T16) mit einem Ausgang (A1) einer vorausgehenden Regelstufe und der Kollektor des weiteren Transistors (T21) mit dem anderen Ausgang (A2) einer vorausgehenden Regelstufe verbunden ist.

18. Regelschaltung nach einem der Ansprüche 1 bis 17, dadurch gekennzeichnet, daß die Steuerspannungsquelle (Vc) die erste (T11) der beiden Stromquellen steuert und daß die Basis der zweiten (T12) der beiden Stromquellen (T11, T12) über einen Kondensator (Co) mit der Basis der ersten (T11) der beiden Stromquellen verbunden ist.

19. Regelschaltung nach einem der Ansprüche 1 bis 18, dadurch gekennzeichnet, daß bei der Hintereinanderschaltung mehrerer Regelstufen an den Ausgängen (A1', A2') der letzten Regelstufe Transistoren (T17, T18) in Emitterschaltung angeschlossen sind, die auf einen Stromspiegel (T19, T20) arbeiten, und daß der Ausgang des Stromspiegels (T19, T20) mit dem Basiseingang der zweiten (T12) der beiden Transistorstromquellen (T11, T12) und dem Kondensator (Co) verbunden ist.

20. Regelschaltung nach einem der Ansprüche 1 bis 19, dadurch gekennzeichnet, daß die an den Ausgängen der letzten Regelstufe angeschlossenen Transistoren (T17, T18) durch Emitterwiderstände (R10, R11) gegengekoppelt sind.

## Claims

1. A control circuit, more particularly for small supply voltages, which has a first transistor (T1), which is operated in common-emitter connection, a second transistor (T2), which is operated in common-emitter connection, and a third transistor (T3) and a fourth transistor (T4) as output transistors, in which the output transistors (T3,T4) are complementary to the first and second transistors (T1,T2), **characterised in that** the bases of the output transistors (T3,T4) are connected together and to a first terminal of a first resistor (R1) and to a first terminal of a second resistor (R2), that the collector of the third transistor (T3) is connected to the collector of the first transistor (T1) and to a second terminal of the first resistor (R1), that the collector of the fourth transistor (T4) is connected to the collector of the second transistor (T2) and to a second terminal of the second resistor (R2), that in order to control the first and second transistors (T1, T2) a control voltage source (Vco) is provided and that moreover there is a signal source (Vi) which controls at least one of the two transistors (T1,T2) together with the control voltage source (Vco).

2. A control circuit according to claim 1, **characterised in that** it has two inputs (E1,E2) and that the base of the first transistor (T1) forms one input (E1) and the base of the second transistor (T2) forms the other input (E2).

3. A control circuit according to claim 1 or 2, **characterised in that** a first signal source (Vi1) is connected between the control voltage source (Vco) and the first input (E1), that a second signal source (Vi2) is connected between the control voltage source (Vco) and the second input (E2) and that both signal sources operate in push-pull with respect to each other.

4. A control circuit according to any one of claims 1 to 3, **characterised in that** the control voltage source (Vco) has a control voltage source (Vc), two transistors (T5, T6) and three resistors (R3,R4,R5), that the control voltage source (Vc) controls the sixth transistor (T6) at base and emitter, that the collector of the sixth transistor (T6) is connected to the collector of the fifth transistor (T5) and to the three resistors (R3,R4,R5), that the third resistor (R3) is connected to the base of the first transistor (T1), the fourth resistor (R4) to the base of the second transistor (T2) and the fifth resistor (R5) to the base of the fifth transistor (T5) and that the signal source (Vi) is connected symmetrically to the bases of the first transistor (T1) and of the second transistor (T2).

5. A control circuit according to any one of claims 1 to 4, **characterised in that** the signal source (Vi) is capacitively connected to one of the inputs.

6. A control circuit according to any one of claims 1 to 5, **characterised in that** a monitoring transistor (T8) is associated with the output transistors (T3,T4), that the two output transistors (T3,T4) and the monitoring transistor (T8) have common base and common emitter connections, that a control current source (Ic) and a seventh transistor (T7) are provided, that the collector of the monitoring transistor (T8) is connected to the control current source (Ic) and to the base of the seventh transistor (T7) and that the collector of the seventh transistor (T7) is connected to the connecting point of the series resistors (R3,R4).

7. A control circuit according to claim 6, **characterised in that** the connection point of the series resistors (R3,R4) is connected to the collector of the sixth transistor (T6), to the series resistor (R5) and the collector of the fifth transistor (T5) and that the series resistor (R5) is connected to the base of the fifth transistor (T5).

8. A control circuit according to any one of claims 1 to 7, **characterised in that** the control voltage source (Vco) has two emitter followers (T9,T10) and two transistor current sources (T11,T12) and that one emitter follower (T9) is connected in front of the first transistor (T1) and the other emitter follower (T10) is connected in front of the second transistor (T2).

9. A control circuit according to any one of claims 1 to 8, **characterised in that** the two transistor current sources (T11, T12) are connected at the bases and at the emitters to the control voltage source (Vc) and at the collectors to the emitters of the emitter followers (T9,T10).

10. A control circuit according to any one of claims 1 to 9, **characterised in that** a current mirror (T13,T14) is provided to which is supplied one of the control currents, and that the collector of the monitoring transistor (T8) is connected to the output of the current mirror (T13,T14) and the base of the seventh transistor (T7) and that the collector of the seventh transistor (T7) is connected to the base of the second transistor (T2).

11. A control circuit according to any one of claims 1 to 10, **characterised in that** when several control stages are connected one after each other the bases of the input transistors (T1',T2') of a following control stage are connected to the outputs (A1,A2) of the preceding control stage.

12. A control circuit according to any one of claims 1 to 11, **characterised in that** the input transistors (T1',T2') of a following control stage have the same sequence of conduction type as the output transistors (T3,T4) of the preceding control stage.

13. A control circuit according to any one of claims 1 to 12, **characterised in that** resistors (R6,R7) are connected between the outputs (A1,A2) of a preceding control stage and the base connections of the input transistors (T1',T2') of the following control stage.

14. A control circuit according to any one of claims 1 to 13, **characterised in that** the bases of the output transistors (T3,T4) of a control stage are connected together via a coupling resistor (R8) and are connected via the resistors (R1,R2) to the collectors of the respective other output transistor (T4,T3).

15. A control circuit according to any one of claims 1 to 14, **characterised in that** a fifteenth transistor (T15) for monitoring overloads is provided with parallel base and emitter connections with the output transistors (T3,T4) and with its collector connected to an operating resistor (R9).

16. A control circuit according to any one of claims 1 to 15, **characterised in that** a sixteenth transistor (T16) is connected by its base to the connection point of the collector of the fifteenth transistor (T15) and the operating resistor (R9) and is connected by its collector to the control voltage source (Vc).

17. A control circuit according to any one of claims 1 to 16, **characterised in that** there is a plurality of control stages, that the fifteenth transistor (T15) is connected to the output of a following control stage, that a further transistor (T21) has parallel base and emitter connections with the sixteenth transistor (T16), that the collector of the sixteenth transistor (T16) is connected to one output (A1) of a preceding control stage and the collector of the further transistor (T21) is connected to the other output (A2) of a preceding control stage.

18. A control circuit according to any one of claims 1 to 17, **characterised in that** the control voltage source (Vc) controls the first (T11) of the two current sources and that the base of the second (T12) of the two current sources (T11,T12) is connected via a capacitor (Co) to the base of the first (T11) of the two current sources.

19. A control circuit according to any one of claims 1 to 18, c**haracterised in that** when several control stages are connected one after the other at the outputs (A1',A2') of the last control stage transistors (T17, T18) are connected in common-emitter mode, said transistors operating on a current mirror (T19,T20) and that the output of the current mirror (T19,T20) is connected to the base input of the second (T12) of the two transistor current sources (T11,T12) and to the capacitor (Co).

20. A control circuit according to any one of claims 1 to 19, **characterised in that** the transistors (T17,T18) connected to the outputs of the last control stage are coupled via emitter resistors (R10,R11).

**Revendications**

1. Circuit de réglage, notamment pour petites tensions d'alimentation, présentant un premier transistor (T1) opérant en émetteur commun, un deuxième transistor (T2) opérant en émetteur commun, et, en tant que transistors de sortie, un troisième transistor (T3) et un quatrième transistor (T4), les transistors de sortie (T3, T4) étant complémentaires par rapport au premier et au deuxième transistor (T1, T2) caractérisé par le fait que les bases des transistors de sortie (T3, T4) sont reliées entre elles ainsi qu'à une première borne d'une première résistance (R1) et à une première borne d'une deuxième résistance (R2), par le fait que le collecteur du troisième transistor (T3) est relié au collecteur du premier transistor (T1) et à une deuxième borne de la première résistance (R1), par le fait que le collecteur du quatrième transistor (T4) est relié au collecteur du deuxième transistor (T2) ainsi qu'à une deuxième borne de la deuxième résistance (R2), par le fait qu'une source de tension de commande (Vco) est prévue pour la commande du premier et du deuxième transistor (T1, T2), et par le fait qu'il y a en outre une source de signal (Vi) qui, conjointement avec la source de tension de commande (Vco), commande au moins l'un des deux transistors (T1, T2).

2. Circuit de réglage selon revendication 1, caractérisé par le fait qu'il présente deux entrées (E1, E2) et par le fait que la base du premier transistor (T1) constitue la première entrée (E1) et la base du deuxième transistor (T2) constitue l'autre entrée (E2).

3. Circuit de réglage selon revendication 1 ou 2, caractérisé par le fait qu'une première source de signal (Vi1) est branchée entre la source de tension de commande (Vco) et la première entrée (E1), par le ait qu'une deuxième source de signal (Vi2) est branchée entre la source de tension de commande (Vco) et la deuxième entrée (E2), et par le fait que les deux sources de signal opèrent en push-pull.

4. Circuit de réglage selon l'une des revendications 1 à 3, caractérisé par le fait que la source de tension de commande (Vco) présente une source de tension de commande (Vc), deux transistors (T5, T6) ainsi que trois résistances (R3, R4, R5), par le fait que la source de tension de commande (Vc) commande le sixième transistor (T6), en sa base et son émetteur, par le fait que le collecteur du sixième transistor (T6) est relié au collecteur du cinquième transistor (T5) ainsi qu'aux trois résistances (R3, R4, R5), par le fait que la troisième résistance (R3) est reliée à la base du premier transistor (T1), la quatrième résistance (R4) est reliée à la base du deuxième transistor (T2) et la cinquième résistance (R5) est reliée à la base du cinquième transistor (T5), et par le fait que la source de signal (Vi) est symétriquement reliée aux bases du premier transistor (T1) et du deuxième transistor (T2).

5. Circuit de réglage selon l'une des revendications 1 à 4, caractérisé par le fait que la source de signal (Vi) est reliée capacitivement à l'une des entrées.

6. Circuit de réglage selon l'une des revendications 1 à 5, caractérisé par le fait qu'un transistor de contrôle (T8) est associé aux transistors de sortie (T3, 74), par le fait que les deux transistors de sortie (T3, T4) et le transistor de contrôle (T8) présentent des bornes de base et d'émetteur communes, par le fait qu'une source de courant de commande (Ic) et un septième transistor (T7) sont prévus, par le fait que le collecteur du transistor de contrôle (T8) est relié à la source de courant de commande (Ic) ainsi qu'à la base du septième transistor (T7), et par le fait que le collecteur du septième transistor (T7) est raccordé au point de connexion des résistances série (R3, R4).

7. Circuit de réglage selon revendication 6, caractérisé par le fait que le point de connexion des résistances série (R3, R4) est relié au collecteur du sixième transistor (T6), à la résistance série (R5) et au collecteur du cinquième transistor (T5), et par le fait que la résistance série (R5) est reliée à la base du cinquième transistor (T5).

8. Circuit de réglage selon l'une des revendications 1 à 7, caractérisé par le fait que la source de tension de commande (Vco) présente deux émetteurs-suiveurs (T9, T10) ainsi que deux sources de courant à transistor (T11, (T12), et par le fait que le premier émetteur-suiveur (T9) est en amont du premier transistor (T1) et l'autre émetteur-suiveur (T10) est en amont du deuxième transistor (T2).

9. Circuit de réglage selon l'une des revendications 1 à 8, caractérisé par le fait que les deux sources de courant à transistor (T11, T12) sont reliées, par les bases et par les émetteurs, à la source de tension de commande (Vc) et, par les collecteurs, aux émetteurs des émetteurs-suiveurs (T9, T10).

10. Circuit de réglage selon l'une des revendications 1 à 9, caractérisé par le fait qu'il est prévu un miroir de courant (T13, T14) auquel est amené l'un des courants de commande, et par le fait que le collecteur du transistor de contrôle (T8) est relié à la sortie du miroir de courant (T13, T14) et à la base du septième transistor (T7), et par le fait que le collecteur du septième transistor (T7) est relié à la base du deuxième transistor (T2).

11. Circuit de réglage selon l'une des revendications 1 à 10, caractérisé par le fait que dans le cas d'un montage en cascade de plusieurs étages de réglage les bases des transistors d'entrée (T1', T2') d'un étage suivant sont reliées aux sorties (A1, A2) de l'étage de réglage précédent.

12. Circuit de réglage selon l'une des revendications 1 à 11, caractérisé par le fait que les transistors d'entrée (T1', T2') d'un étage de réglage suivant présentent la même séquence de types de conductibilité que les transistors de sortie (T3, T4) de l'étage de réglage précédent.

13. Circuit de réglage selon l'une de revendications 1 à 12, caractérisé par le fait que des résistances (R6, R7) sont branchées entre les sorties (A1, A2) d'un étage de réglage précédent et les bornes de base des transistors d'entrée (T1', T2') de l'étage de réglage suivant.

14. Circuit de réglage selon l'une des revendications 1 à 13, caractérisé par le fait que les bases des transistors de sortie (T3, T4) d'un étage de réglage sont reliées l'une à l'autre par une résistance de couplage positif (R8) et sont reliées, par les résistances (R1, R2), aux collecteurs de l'autre transistor de sortie concerné (T4, T3).

15. Circuit de réglage selon l'une des revendications 1 à 14, caractérisé par le fait qu'un quinzième transistor (T15) est prévu pour le contrôle de saturations, ce transistor étant relié en parallèle aux transistors de sortie (T3, T4), cela par les bases et émetteurs, et ayant son collecteur relié a une résistance de travail (R9).

16. Circuit de réglage selon l'une des revendications 1 à 15, caractérisé par le fait qu'un seizième transistor (T16) est raccordé par sa base au point de connexion du collecteur du quinzième transistor (T15) et à la résistance de travail (R9) et est relié par son collecteur, à la source de tension de commande (Vc).

17. Circuit de réglage selon l'une des revendications 1 à 16, caractérise par le fait qu'il y a plusieurs étages de réglage, par le fait que le quinzième transistor (T15) est relié à la sortie d'un étage de réglage suivant, par le fait que le seizième transistor (T16) est raccordé en parallèle à un autre transistor (T21), cela par les bases et les émetteurs, par le fait que le collecteur du seizième transistor (T16) est relié à une sortie (A1) d'un étage de réglage précédent et le collecteur de l'autre transistor (T21) est relié à l'autre sortie (A2) d'un étage de réglage précédent.

18. Circuit de réglage selon l'une des revendications 1 à 17, caractérisé par le fait que la source de tension de commande (Vc) commande la première (T11) des deux sources de courant, et par le fait que la base de la deuxième (T12) des deux sources de courant (T11, T12) est reliée par un condensateur (Co) à la base de la première (T11) des deux sources de courant.

19. Circuit de réglage selon l'une des revendications 1 à 18, caractérisé par le fait que, plusieurs étages de réglage étant branchés en cascade, des transistors (T17, T18) en montage "émetteur commun" sont raccordés aux sorties (A1', A2') du dernier étage de réglage, ces transistors opérant sur un miroir de courant (T19, T20), et par le fait que la sortie du miroir de courant (T19, T20) est reliée à l'entrée-base de la deuxième (T12) des deux sources de courant à transistor (T11, T12), et au condensateur (Co).

20. Circuit de réglage selon l'une des revendications 1 à 19, caractérisé par le fait que les transistors (T17, T18) raccordés aux sorties du dernier étage de réglage sont contre-couplés par des résistances d'émetteur (R10, R11).

FIG.1

FIG.2

FIG.3

FIG.4

FIG.5

FIG.6

FIG.7

15

FIG.8

FIG. 9

FIG. 10

FIG. 11

FIG.12

FIG.13